Europäisches Patentamt

European Patent Office

Office européen des brevets

(11) Publication number: **0 218 420**
**A2**

## (12) EUROPEAN PATENT APPLICATION

(21) Application number: **86307380.5**

(22) Date of filing: **25.09.86**

(51) Int. Cl.⁴: **G 06 F 15/60**

(30) Priority: **30.09.85 US 781837**

(43) Date of publication of application: **15.04.87**
**Bulletin 87/16**

(84) Designated Contracting States: **DE GB NL**

(71) Applicant: **CAE SYSTEMS, INC., 5302 Betsy Ross Drive, Santa Clara California 95050 (US)**

(72) Inventor: **Karger, Patrick G., 3503 Pinnacle, Austin Texas 78746 (US)**

(74) Representative: **Burke, Steven David et al, R.G.C. Jenkins & Co. 12-15, Fetter Lane, London EC4A 1PL (GB)**

(54) Constrained optimization component placement system.

(57) A constrained optimization component placement system uses wire length as the objective function being minimized and uses routing resource congestion to define a constraint function to be satisfied. A carrier is partitioned into rectangles and iterative exchange placement and pin assignment is carried out for all components within each rectangle. If the new score using the constrained optimization function is less than the old score, the exchange is accepted, otherwise the exchange is rejected. Each rectangle is subsequently partitioned and the process repeated until a terminal condition, such as routing complete, is achieved.

ACTORUM AG

CONSTRAINED OPTIMIZATION
COMPONENT PLACEMENT SYSTEM

## Background of the Invention

### Field of the Invention.

The present invention relates to the placement of components on a carrier, and more particularly to a constrained optimization component placement system in which wire length is the objective function being minimized and routing resource congestion is used to define a constraint function that must be satisfied.

### Description of the Prior Art.

The component placement problem when applied to digital circuits consists of finding the optimal arrangement of components on a carrier with respect to some predefined criteria, such as total wire length. The carrier is the medium on which the circuit is laid out, such as a semiconductor chip or printed circuit board, and component refers to a physical entity containing one or more circuit elements, such as gates or macro cells on a chip or chips on a printed circuit board. Finding the optimal arrangement of components potentially involves evaluating n! possible configurations where n is the number of components. Since modern placement problems involve thousands of components, such a combinatorial approach is impractical. Therefore, many heuristics have been developed in an attempt to approach the optimum solution. The actual component placement task typically is performed in two phases: 1) constructive initial placement and 2) iterative improvement placement.

Constructive initial placement begins with all or part of the components unplaced and determines an initial location for each component on the carrier surface. Once a component is positioned, it generally is not moved. Some current initial placement algorithms include cluster development which forms the initial placement by selecting components one at a time to connect to previously placed components; min-cut techniques which attempt to place devices such that crossings of cut lines are minimized; and least squares method which forms the initial placement by forming a system of equations using eigenvector techniques, solving for the optimum solution and then mapping onto the carrier. In all of these techniques, there is room for substantial error. In the cluster development and min-cut algorithms this error stems from choosing components and placing them with only partial information, and in the least squares algorithm this error stems from distortions which occur when mapping the idealized placement onto the carrier. Thus, it is necessary to follow the initial placement phase with an iterative improvement phase.

The goal of iterative improvement placement is to take a set of initially placed components and attempt to improve that placement. Normally iterative improvement placers are limited to interchanging components between "slots" on the carrier which indicate legal locations for certain types and sizes of components. These slots are defined based on the initial positons and attributes of the components being considered. This restriction eliminates the need to dynamically check for component overlap and thus results in much faster placement techniques. Most of the techniques involve choosing a primary component and then searching for a secondary component location to which the primary component can be moved to improve the placement. Such algorithms include force directed pairwise interchange and unconnected set interchange. All of these techniques ultimately must rely on a scoring metric for judging the quality of the placement, i.e., for determining whether one arrangement of components is better or worse than some other arrangement. Since the final goal is to complete all of the interconnections, the best metric would be the routing completion rate. Since it is infeasible to actually perform routing for each trial arrangement of components, it is necessary to use some metric which can be quickly computed and which correlates strongly with the routing completion rate, such as expected wire length.

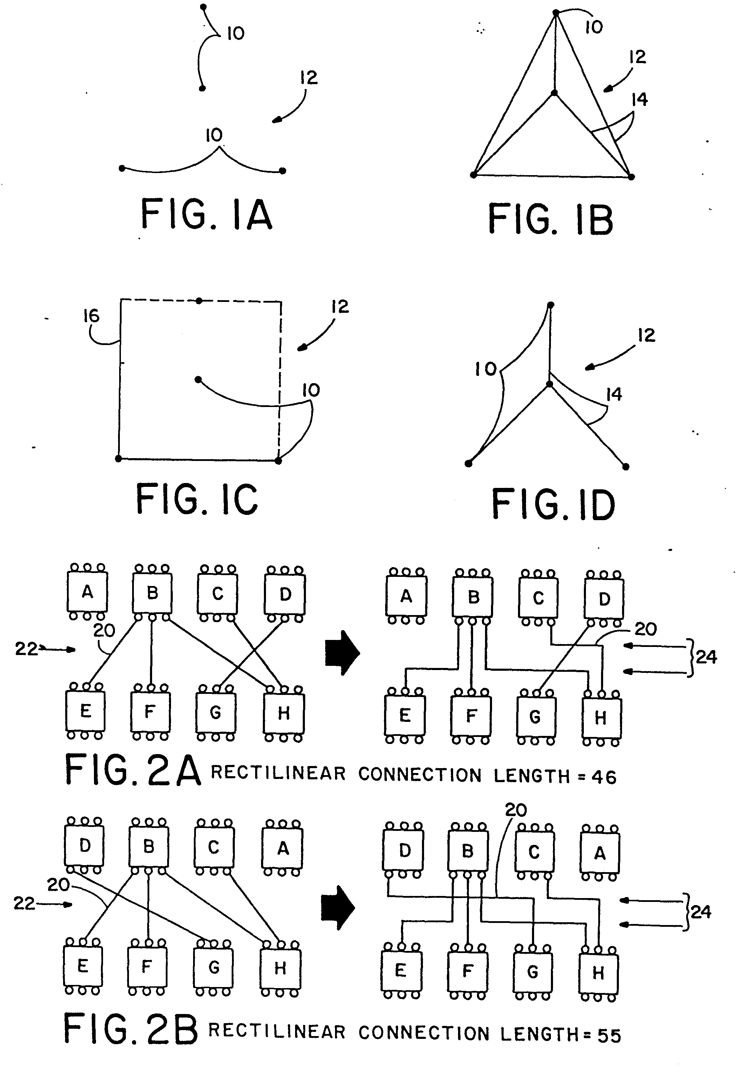

The wire length metric can be computed in many different ways as shown in Fig. 1. The idea behind this metric is that, as the wire length decreases, the routing resources required to complete the interconnections decrease and the routing completion rate should increase. In Fig. 1a for the nodes 10 in a net 12 to be interconnected, one way is to form the complete graph, as shown in Fig. 1b, for each net and sum either the rectilinear or Euclidean length of each of the edges 14. This is clearly pessimistic in terms of actual wire length required to form the interconnections since only one path is required from one node to any other node. Another method shown in Fig. 1c is to sum up over all nets half of the perimeter distance of the minimum bounding box 16 enclosing the net 12. The wire length estimated by this method represents the absolute minimum wire length required to complete the interconnections using rectilinear paths. A third technique shown in Fig. 1d. is to generate a minimum spanning tree (MST) for the net based upon the imposed wiring rules and summing up either the rectilinear or Euclidean length of each edge 14 in the graph. This last is the most accurate of these methods since it most closely models the way in which a router tries to optimally route the interconnections.

While using the wire length as a placement metric does give a good estimation of the total resources required for routing, it does not take into consideration which resources are used or how those resources are distributed. If the use and distribution of resources are not considered, it is possible to create regions of high congestion where enough routing resources do not exist to complete the required interconnections. This is shown in Fig. 2a where a network requiring five interconnections 20 has a total rectilinear connection length of 46 units. The available routing resource consists of one channel 22 with two tracks 24. An area of high congestion exists on the right side of the channel 22 due to connections C-H, B-H and D-G competing for the same routing tracks. In this case the congestion has forced connection D-G to fail. The interchanging of components A and D as shown in Fig. 2b increases the rectilinear connection length to 55 units, but the congestion is diminished and all connections are successfully completed.

The example of Fig. 2 illustrates how simply minimizing wire length can cause routing failures to occur by creating regions of local congestion.

Therefore an iterative improvement placement technique is desired which prevents such regions of local congestion.

## Summary of the Invention

Accordingly the present invention provides a constrained optimization component placement system in which wire length is the objective function being minimized and routing resource congestion is used to define a constraint function that must be satisfied. A carrier is partitioned into rectangles and iterative exchange placement is carried out for all components within each rectangle simultaneously with pin assignment. If the new score using the constrained optimization function is less than the old score, the exchange is accepted, otherwise the exchange is rejected. Each rectangle is subsequently partitioned and the process repeated until a terminal condition, such as minimum number of components within a rectangle, is achieved.

The objects, advantages and novel features of the present invention will be apparent from the following detailed description when read in conjunction with the appended claims and attached drawing.

## Brief Description of Drawings

Figs. 1a, 1b, 1c and 1d illustrate various methods for estimating the wire length required to interconnect a graph.

Figs. 2a and 2b illustrate a routing failure caused by congestion.

Figs. 3a, 3b, 3c and 3d illustrate a sample interconnection and possible rectilinear routing paths.

Figs. 4a and 4b illustrate uniform utilization of routing resources over an interconnection bounding box.

Figs. 5a and 5b illustrate variation in congestion resolution due to cell size.

Figs. 6a, 6b and 6c illustrate advantages of concurrent component placement and pin assignment.

## Description of the Preferred Embodiment

To solve the local congestion problem the iterative improvement phase of component placement is viewed as a constrained optimization problem. In constrained optimization problems there exists a function called the objective function whose value is to be minimized (or maximized) subject to some constraints on the values which the function or its parameters can assume. An example is to minimize $F(x) = x^2+2x+3$ subject to $x \geq 1$. In this case $F(x)$ is the objective function and $x \geq 1$ is the constraint function. The solution for this problem is $F(x) = 6$ which occurs at $x = 1$.

A technique for solving the constrained optimization problem is a penalty function method. In this approach a modified objective function is formed by adding a penalty term $P(x)$ to the original objective function to account for the constraints, i.e., $J = F(x)+P(x)$. In component placement it is not necessary to drive the constraint to zero, but only to reach some acceptable balance between the objective function (wire length) and the constraint function (congestion). Two possible constraint conditions are "homogeneity" of the routing resource use over the carrier and "capacity violation" of specific routing resources.

Homogeneity of routing resource use means that routing resources needed by net interconnections, pins and routing barriers are roughly equal over the entire carrier surface. The deviation one is willing to accept to reduce the wire length is controlled by the weight W given to the penalty term. Smoothing out the routing resource use has two primary advantages: 1) congestion build up is constrained so that fewer connections fail due to lack of sufficient local routing resources and 2) potential thermal effect problems are lessened since energy and heat dissipation tends to be evened out along with routing resource use. A homogeneity constraint function is as follows:

$$p = ([\sum_{i=1}^{n}(ei-u)^2]/n)^{1/2}$$

where     n = number of cells ei = expected use of cell i

$$u = \text{mean use per cell} = [\sum_{i=1}^{n}ei]/n$$

However, the homogeneity constraint may unnecessarily increase the wire length, especially if the total amount of routing resources available substantially exceeds the amount needed to complete the specified interconnections. The less constrained the objective function is, the better the chances are that the minimum of the constrained optimization problem approaches the minimum of the unconstrained optimization problem.

The capacity violation constraint is concerned with whether any of the routing resources are over used, i.e., whether any routing resources are used beyond some given (or calculated) capacity limits such that routing failures are likely to result. Capacity is used as a measure of the amount of available routing resource per unit area. This constraint is less constricting since it only prevents wire length reduction in cases where the routing resource capacity would be exceeded. The capacity violation constraint function may be written as:

$$p = \sum_{i=1}^{n} [(e_i-c_i)g(e_i-c_i)]/n$$

where $g(x) = 0 \ (x \leq 0); \ 1 \ (x > 0)$

$c_i$ = capacity of cell i

The position and amount of routing resources consumed by pins and routing barriers is known, but not those for the interconnections. The amount of routing resources needed is approximately equal to the Euclidean or rectilinear length of the specific connection being considered. The exact path that the route takes is not known.

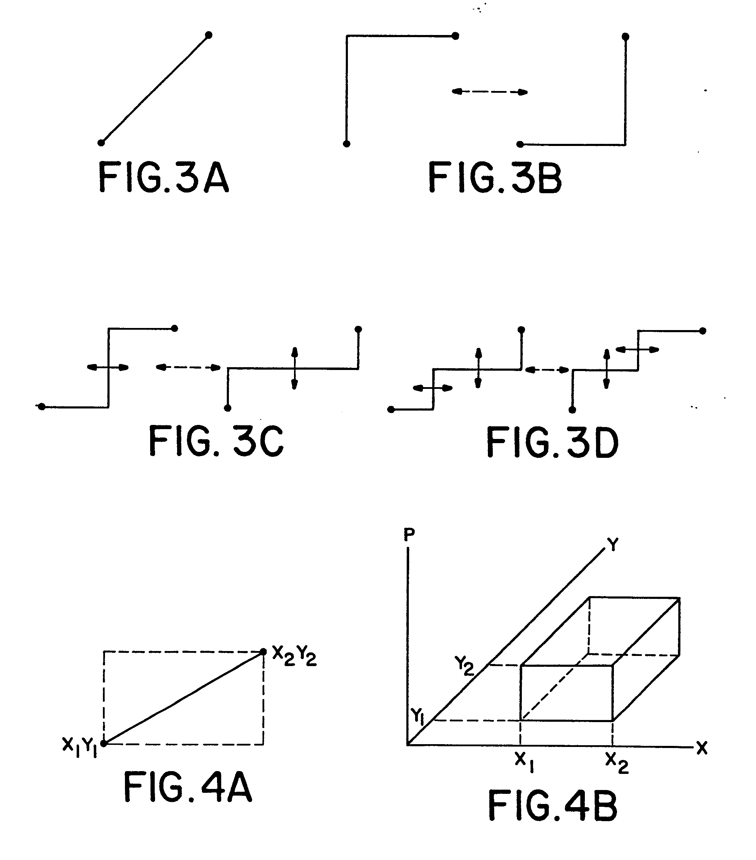

A sample interconnection is shown in Fig. 3 for some of the possible routing paths. This assumes that only rectilinear, non-meandering paths are allowed. Since normally making a bend in a routing path is expensive because of the need for via insertion or non-preferred wiring, the more bends in a path the less likely the path is generated. However, exactly where bends occur is so dependent on the order in which the connections are routed and the nature of the router that it is not possible to predict with any accuracy. Thus, a uniform distribution of required routing resources over the area of a rectangle which bounds the connection is assumed, as shown in Fig. 4.

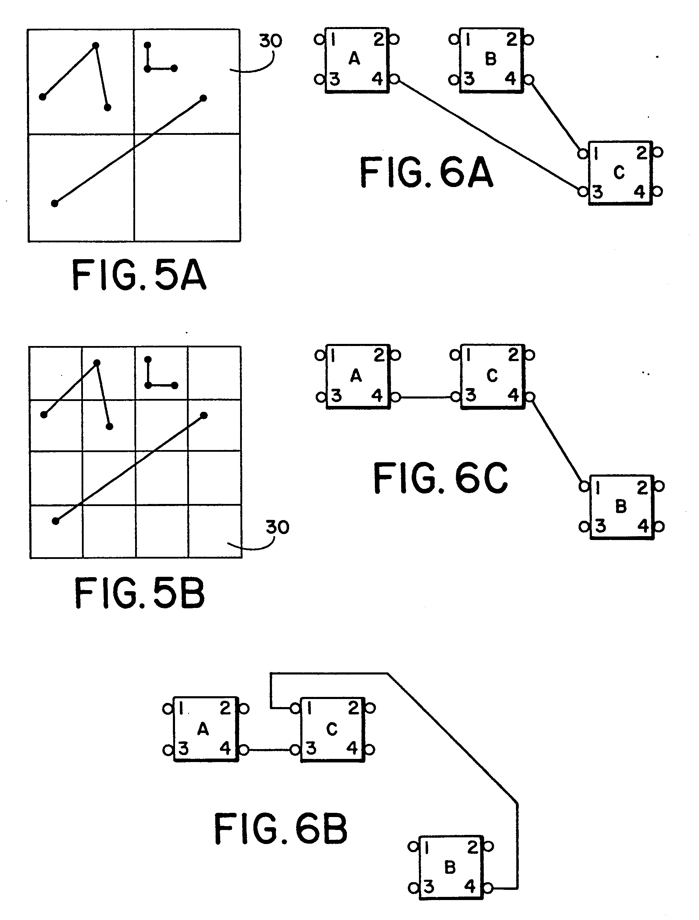

To keep track of this use where the interaction of all of the connections, pins and routing barriers is considered requires storing the routing resource use over some unit area of the carrier. This is done by subdividing the carrier into a two dimensional array of cells 30 as shown in Fig. 5. Each cell represents a certain area of the carrier and, therefore, a certain capacity of routing resources. The routing resource use is tracked by calculating the expected cell use for each connection, with the exact cell use for pins and routing barriers being known. The expected cell use for the connections and the exact cell use for the pins and routing barriers is added together for each cell. The size of the cell used determines the level of resolution with which the congestion is viewed. If the cells are too large, then the differences between various configurations cannot be seen. Ideally, the cell size should equal the track width so that any variation in congestion between various component configurations can be identified. But the decrease in cell size increases the number of cells and computation time required to calculate expected use of the cells.

However, an extremely small cell size is needed only when taking a microscopic view of the carrier. Therefore, a hierarchical approach is used. Large cell sizes are used at first when making global corrections to the component arrangement, and then the carrier is subdivided down into independent partitions, reducing the cell size within each partition. Thus, the number of cells is kept approximately constant while continually increasing the resolution. Since global adjustments occurred at previous levels in the hierarchy, only local adjustments to the components within the partition are required. Once the expected use of each cell is known, the appropriate constraint function is applied and the value of the modified objective function is calculated.

A final consideration is concurrent component placement and pin assignment. Current placers, when searching for good placements, do so by representing the interconnections as being to some predefined point(s) on the components. As shown in Fig. 6 this results in suboptimal modeling of the interconnections when judging the quality of the placement. The best pin to connect to on the component may change based on the relative position of the components. Thus, new placements are generated based on component connection points which may be potentially far from optimal. Therefore, after each trial placement, or only after successful trial placements, pin assignment is performed. The pin assignment is scored using the same function as for component placement.

The placement algorithm may be described as follows:

```
UNTIL bottom level
    FOR each rectangle
        Load data for components in this rectangle
        Precharge cells with existing components,
            barriers and pins
        UNTIL stop condition
            Select components to exchange
            Save current placement
            Exchange components
```

```
        Score new placement
        UNTIL stop condition
            Select pins to exchange
            Save current pin assignment
            Exchange pins
            Score current placement and pin
                assignment
            IF (new score < old score) then
                update pin assignment
            ELSE restore old pin assignment
        ENDUNTIL
        IF (new score < old score) then accept
            new placement
        ELSE restore old placement
        ENDIF
      ENDUNTIL
    ENDFOR
  ENDUNTIL
```

The scoring function, based on the modified objective function, is u + Wp where W is a weighting factor, u is the mean cell utilization which has a direct relationship to wire length, and p is the penalty term using homogeneity or capacity violation criteria. The scoring function is used to achieve an optimum balance between wire length and congestion.

Thus, the present invention provides an iterative improvement placement system which supplies a congestion constraint to an objective wire length function, concurrently places components and makes pin assignments, and uses a hierarchical approach to increase resolution resulting in a near optimum component placement system which reduces interconnect failures.

0218420

- 12 -

CLAIMS:

1. A constrained optimization component placement system comprising:

means for iteratively interchanging components initially placed on a carrier;

means for scoring the improvement of each component interchange toward an optimum placement based upon an objective function and a weighted constraint function; and

means for restoring said components to their original placements if the result of said scoring means moves away from said optimum placement.

2. A system as recited in claim 1 further system comprising:

means for iteratively interchanging pin assignments after each interchange of components; and

means for scoring the improvement of each pin assignment interchange toward said optimum placement;

means for restoring said pin assignments to their original assignments if the result of said scoring means moves away from said optimum placement.

3. A system as recited in claim 2 further comprising:

means for initially partitioning said carrier into a plurality of rectangles each having a plurality of cells such that said interchanging means are constrained to each of said rectangles; and

means for iteratively partitioning each of said rectangles into smaller rectangles having approximately the same number of said cells such that

0218420

- 13 -

said interchanging means are exercised at each level of such a hierarchy until a terminal condition is achieved.

4. A system as recited in claim 3 wherein said objective function is a mean cell use which is directly related to the total wire length needed to interconnect said components, and said weighted constraint function is a penalty function selected from the group consisting of a homogeneity constraint and a capacity violation constraint, said penalty function being chosen to prevent local congestion of routing resources so that all interconnections between said components are completed.

FIG. IA

FIG. IB

FIG. IC

FIG. ID

FIG.2A RECTILINEAR CONNECTION LENGTH = 46

FIG.2B RECTILINEAR CONNECTION LENGTH = 55

2/3

0218420

FIG.3A

FIG.3B

FIG. 3C

FIG.3D

FIG.4A

FIG.4B

FIG.5A

FIG.6A

FIG.5B

FIG.6C

FIG.6B

3/3

0218420